Europäisches Patentamt

European Patent Office

Office européen des brevets

(11) Publication number: **0 287 195**
**A1**

# EUROPEAN PATENT APPLICATION

(21) Application number: **88301192.6**

(51) Int. Cl.4: **H01L 27/06 , H01L 29/62**

(22) Date of filing: **12.02.88**

| | |
|---|---|
| The title of the invention has been amended (Guidelines for Examination in the EPO, A-III, 7.3). | (71) Applicant: **SILICONIX incorporated** <br> **2201 Laurelwood Road** <br> **Santa Clara California 95054(US)** |
| (30) Priority: **17.02.87 US 14962** | (72) Inventor: **Blanchard, Richard A.** <br> **10724 Mora Drive** <br> **Los Altos California 94022(US)** <br> Inventor: **Cogan, Adrian I.** <br> **1174 Hyde Avenue** <br> **San Jose California 95129(US)** |
| (43) Date of publication of application: <br> **19.10.88 Bulletin 88/42** | |
| (84) Designated Contracting States: <br> **BE DE FR GB IT NL** | (74) Representative: **Jones, Ian et al** <br> **POLLAK MERCER & TENCH High Holborn** <br> **House 52-54 High Holborn** <br> **London WC1V 6RY(GB)** |

(54) **Power MOS transistor with integrated resistor.**

(57) A power MOS transistor includes a polycrystalline silicon layer (18) which provides connection to act as a resistor between the first portion (26) of gate metallization disposed above the gate of the device, and a second portion (28) of gate metallization adjacent to the active source/gate region of the device.

FIG. 3

FIG. 1

EP 0 287 195 A1

## SEMICONDUCTOR DEVICE

This invention relates to a semiconductor device and to a transistor, in particular a power transistor.

In applications requiring the paralleling of power MOS transistors (whether lateral or vertical devices), the high gain, high frequency characteristics of these devices make them prone to oscillation. In the past, two techniques have been used to reduce unwanted oscillation, as follows.

1. The gate geometry may be designed so that its distributed resistance minimizes the occurrence of the oscillations.

2. A resistor may be placed in series with portions of the gate metallization of the transistor.

While both of these techniques have been found effective, each has certain disadvantages.

The presence of distributed gate resistance has been found to slow the propagation of the gate drive signal across the device when rapid turn on or turn off is required. This distributed resistance establishes a minimum device response time which may be unsatisfactory.

The use of an external resistor in series with portions of the gate metallization increases device complexity and make also require additional chip area.

In order to overcome the problems set forth above, the present invention provides for the inclusion, in a semiconductor device or transistor, of a resistor between the gate pad and the active path region of the device, which resistor is integrated as part of the device.

Thus there can be provided in accordance with this invention a power transistor having an integrated gate resistor, comprising a semiconductor substrate having a first region of a first conductivity type and a second region of a second conductivity type adjacent the first region, and forming a junction with the first region, an insulating layer over at least a portion of the first region and at least a portion of the second region, a first conductive gate element adjacent the first region, with the insulating layer between the first conductive gate element and the first region, a second conductive gate element adjacent the second region and spaced from the first conductive gate element, with the insulating layer between the substrate and second conductive gate element, and a resistor on the insulating layer contacting the first and second conductive elements.

The present invention provides for significant reduction of device oscillation, without slowing of propagation of the gate drive signal across the device when rapid turn on and turn off is reqired, and avoids complexity, and use of additional chip area over the standard device.

The invention is further described below, by way of example, with reference to the accompanying drawings, in which:

Fig. 1 is a plan view of an interdigitated vertical DMOS power transistor incorporating the invention;

Fig. 2 is a sectional view taken along the line II-II of Fig. 1; and

Fig. 3 is a schematic view of a transistor incorporating the invention.

Referring to the drawings, a DMOS power transistor 10 is shown therein. Such device 10 includes a semiconductor substrate 12 of N conductivity type, and a region of P conductivity type 14 formed therein, so that the region 14 is generally surrounded by N conductivity type region 13, and forms a P-N junction with the region 13. A thick layer of oxide 16 (in order to minimize capacitance) is formed over the surface of the substrate 12, covering the P-region 14 and at least a portion of the N-region 13 adjacent the P-region 14.

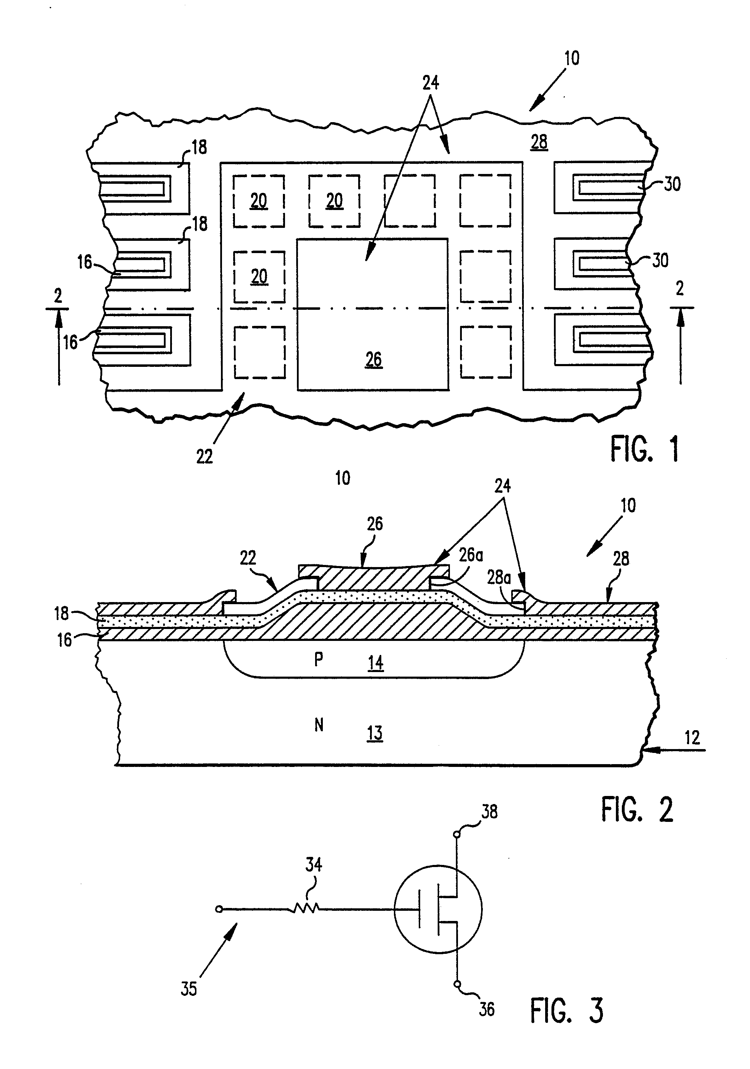

A layer of doped polycrystalline silicon 18 is formed over the oxide layer 16, and openings 20 are provided therethrough (Fig. 1).

An additional oxide layer 22 is provided over the polycrystalline silicon layer 18 and is patterned to define contact windows for gate metallization 24. Such gate metallization 24 is provided in the patterns shown in the drawings. The gate metallization 24 is of conductive metal (for example, aluminium) and has a first portion 26 positioned adjacent and generally over the region 14, and a second portion 28 generally surrounding the first portion 26 and adjacent and generally over the region 13.

The gate metallization portion 28, polycrystalline silicon layer 18, and oxide layer 16 are further patterned to determine openings therein so that source metallization portions 30 can contact as appropriate the region 13 of the device 10.

In the use of the device 10, the portion of polycrystalline silicon layer 18 extending between the edges 26a, 28a of metallization portions 26, 28, respectively, acts as a resistor element contacting those conductive elements 26, 28 and extending therebetween. In fact, the layout of the device 10 is such that the effective resistor dimension of the resistor element extends from the edge 26a of the metallization portion 26 to the edge 28a and to adjacent the junction of the regions 14, 13.

The size of the openings in the polycrystalline silicon layer 18, along with the effective dimensions of the resistor element as described above and the doping level of the polycrystalline silicon layer 18, may all be varied and chosen as appropriate to the specific device and application thereof.

For example, in a specific environment, doping with arsenic to the level of $10^{15}$ atoms/cm³ can provide a sheet resistance of 100 ohms/sq. while doping with arsenic to a level of $10^{16}$ atoms/cm³ can provide a sheet resistance of 100 ohms/sq. Boron and phosphorous, or combination of the these dopants, can also be used.

The resulting circuit of the device of the present invention is set forth in Fig. 3, showing a resistor 34 in the gate line 35, and a source 36 and drain 38.

In this manner, the use of a resistor that is integrated into the device between gate metallization portions of the power MOS transistor and extending to the active source-gate junction adds the series resistance needed to prevent unwanted oscillations of the device.

Meanwhile, since valuable chip area is saved, the resulting small die size provides the advantages of high speed operation, along with high yield end resulting low cost of the device.

In applications requiring the use of the power MOS transistors in series, direct metallization connections between the gate metallization portions 26, 28 can be made, bypassing the resistor structure described.

oxide 16 (in order to minimize capacitance) is formed over the surface of the substrate 12, covering the P-region 14 and at least a portion of the N-region 13 adjacent the P-region 14.

A layer of doped polycrystalline silicon 18 is formed over the oxide layer 16, and openings 20 are provided therethrough (Fig. 1).

An additional oxide layer 22 is provided over the polycrystalline silicon layer 18 and is patterned to define contact windows for gate metallization 24. Such gate metallization 24 is provided in the patterns shown in the drawings. The gate metallization 24 is of conductive metal (for example, aluminum) and has a first portion 26 positioned adjacent and generally over the region 14, and a second portion 28 generally surrounding the first portion 26 and adjacent and generally over the region 13.

The gate metallization portion 28, polycrystalline silicon layer 18, and oxide layer 16 are further patterned to determine openings therein so that source metallization portions 30 can contact as appropriate the region 13 of the device 10.

In the use of the device 10, the portion of polycrystalline silicon layer 18 extending between the edges 26a, 28a of metallization portions 26, 28, respectively, acts as a resistor element contacting those conductive elements 26, 28 and extending therebetween. In fact, the layout of the device 10 is such that the effective resistor dimension of the resistor element extends from the edge 26a of the metallization portion 26 to the edge 28a and to adjacent the junction of the regions 14, 13.

The size of the openings in the polycrystalline silicon layer 18, along with the effective dimensions of the resistor element as described above and the doping level of the polycrystalline silicon layer 18, may all be varied and chosen as appropriate to the specific device and application thereof.

For example, in a specific environment, doping with arsenic to the level of $10^{15}$ atoms/cm³ can provide a sheet resistance of 1000 ohms/sq. while doping with arsenic to a level of $10^{16}$ atoms/cm³ can provide a sheet resistance of 100 ohms/sq. Boron and phosphorous, or combination of the these dopants, can also be used.

The resulting circuit of the device of the present invention is set forth in Fig. 3, showing a resistor 34 in the gate line 35, and a source 36 and drain 38.

In this manner, the use of a resistor that is integrated into the device between gate metallization portions of the power MOS transistor and extending to the active source-gate junction adds the series resistance needed to prevent unwanted oscillations of the device.

Meanwhile, since valuable chip area is saved, the resulting small die size provides the advantages of high speed operation, along with high yield end resulting low cost of the device.

In applications requiring the use of the power MOS transistors in series, direct metallization connections between the gate metallization portions 26, 28 can be made, bypassing the resistor structure described.

## Claims

1 A semiconductor device with a semiconductor substrate having a region of a conductivity type and

an insulating layer over at least a portion of the semiconductor substrate, characterized by

first and second spaced apart conductive elements (26 and 28), with the insulating layer (16) between the substrate (12) and the first conductive element and between the substrate and the second conductive element, and

a resistor (18) contacting the first and second conductive elements (26, 28), with the insulating layer (16) between the resistor and the substrate.

2 A semiconductor device as claimed in Claim 1 characterized in that the resistor (18) is on the insulating layer (16).

3 A semiconductor device as claimed in Claim 1 or 2 characterized in that the resistor (18) comprises doped polycrystalline silicon.

4 A semiconductor device as claimed in Claim 1, 2 or 3 characterized in that the resistor (18) has an effective resistor dimension extending from the first conductive element (26) to the second conductive element (28).

5 A transistor with a semiconductor substrate (12) having a first region (14) of a first conductivity type and a second region (13) of a second, opposite, conductivity type adjacent the first region and forming a junction therewith, and an insulating layer (16) over at least a portion of the first region and at least a portion of the second region, characterized by

first gate conductive element (26) adjacent the first region (14), with the insulating layer (16) between the first conductive gate element and the first region;

a second conductive element (28) adjacent to the second region and spaced from the first conductive gate element, with the insulating layer (16) between the substrate and second conductive gate element; and

a resistor (18) on the insulating layer contacting the first and second conductive gate elements.

6 A transistor as claimed in Claim 5 characterized in that the resistor comprises doped polycrystalline silicon.

7 A transistor as claimed in Claim 5 or 6 characterized by a second insulating layer (22) over the resistor and contacting the first and second conductive gate elements (26, 28).

8 A transistor with a semiconductor substrate (12) having a first region (14) of a first conductivity type and a second region (13) of a second, opposite conductivity type generally surrounding the first region and forming a junction therewith,

an insulating layer (16) on the substrate over the first region and at least a portion of the second region, characterized by a doped polycrystalline silicon layer (18) on the insulating layer (16);

a first conductive gate element (26) on the polycrystalline silicon layer and positioned generally over the first region (14), and a second conductive gate element (28) on the polycrystalline silicon layer (18) and spaced from and generally surrounding the first conductive gate element (26),

the portion of the polycrystalline silicon layer (18) connecting the first and second conductive gate elements (26, 28) acting as a resistor.

9 A transistor as claimed in Claim 8 characterized by a second insulating layer (22) on the polycrystalline silicon layer and contacting the first and second conductive gate elements.

10 A transistor as claimed in any one of Claims 5-9 characterized in that the resistor has an effective resistor dimension extending from the first conductive gate element (26), to adjacent the junction of the first and second regions (14, 13).

FIG. 1

FIG. 2

FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 10, no. 8 (E-373)[2065], 14th Januar 1986; JP - A - 60 171 771 (HITACHI SEISAKUSHO) 05-09-1985 * abstract; figures 1-6 * | 1-4 | H 01 L 27/06 H 01 L 29/62 |
| A | idem | 5,6,8 | |
| A | US-A-3 999 210 (T. YMADA) * abstract; figure 2, 4; column 2, lines 4-49 * | 1-3,5,6 ,8 | |
| A | JAPANESE JOURNAL OF APPLIED PHYSICS SUPP., vol. 15, no. 7, 1976, pages 179-183; I. YOSHIDA et al.: "A High Power MOS-FET with a Vertical Drain Electrode and Meshed Gate Structure" * abstract; figure 2; page 180, column 1, lines 15-19; column 2, lines 1-5 * | 1-3,5,6 ,8 | |

TECHNICAL FIELDS SEARCHED (Int. Cl.4)

H 01 L

The present search report has been drawn up for all claims

| Place of search | Date of completion of the search | Examiner |
|---|---|---|
| BERLIN | 06-04-1988 | JUHL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)